# EUROPÄISCHE PATENTANMELDUNG

(11) **EP 2 747 275 A2**
(43) Veröffentlichungstag der Anmeldung: **25.06.2014**
(21) Anmeldenummer: 13198148.2
(22) Anmeldetag: 18.12.2013
(51) Int. Cl.: H02S 10/10, H01L 31/052

(54) **Zum Teil transparenter Sonnenkollektor**

(30) Priorität: 18.12.2012 DE 102012024686
(71) Anmelder: Aqua Bio Solar GmbH, 6430 Schwyz (CH)
(72) Erfinder: Packenius, Josef, 12459 Berlin (DE); Eng, Lukas, 01277 Dresden (DE); Stegemann, Bert, 10317 Berlin (DE); Dittrich, Ronald, 99610 Sömmerda (DE)
(74) Vertreter: Liebetanz, Michael

(57) **Zusammenfassung**

Die Erfindung betrifft einen Sonnenkollektor (1), aufweisend mindestens eine zum Teil transparente Fläche (1.1), eine Ebene mit mindestens einem diffraktiven optischen Element (2), wobei die elektromagnetische Strahlung mit einem ersten vorbestimmten Wellenlängenintervall (λ₁) durch eine einer Einfallfläche gegenüberliegenden Rückseite der transparenten Fläche (1.1) austritt und die elektromagnetische Strahlung mit einem zweiten vorbestimmten Wellenlängenintervall (λ₂) durch eine seitliche Stirnfläche (1.3) der transparenten Fläche (1.1) austritt und mindestens eine solarthermische Einheit (5), wobei die solarthermische Einheit (5) seitlich der seitlichen Stirnfläche (1.3) der transparenten Fläche (1.1) angeordnet ist, wobei das mindestens ein photovoltaisches Element (4, 40) derart benachbart zur transparenten Fläche (1.1) angeordnet ist, dass aus der transparenten Fläche (1.1) ausgekoppelte elektromagnetische Strahlung (λ₁, λ₂) dieses bestrahlen.

## Beschreibung

### TECHNISCHES GEBIET

Die Erfindung betrifft einen Sonnenkollektor, aufweisend mindestens eine zum Teil transparente Fläche und mindestens eine solarthermische Einheit, wobei die solarthermische Einheit an der Stirnfläche oder unmittelbar in der Nähe der Stirnfläche der transparenten Fläche angeordnet ist. Die solarthermische Einheit befindet sich vornehmlich im Rahmen des Kollektors.

### STAND DER TECHNIK

Zur Erzeugung von Solarenergie ist es bekannt, großflächige Sonnenkollektoren mit darunterliegenden solarthermischen Einheiten oder photovoltaischen Einheiten im Freien aufzustellen und auf der Nordhalbkugel der Erde in südlicher Richtung geneigt und auf der südlichen Halbkugel in nördlicher Richtung geneigt aufzustellen. Unter den Solarelementen ist es in der Regel schattig. Es gedeihen dort keine oder nur solche Pflanzen, die einen geringen Lichtanspruch haben, wie Moose, kurze Gräser oder Schattengewächse. Zur flächendeckenden Versorgung mit Solarenergie sind aufgrund der auf der Erde herrschenden Energiedichte große Areale mit Sonnenkollektoren auszustatten, um den menschlichen Energiebedarf zu decken.

Sonnenkollektoren oder auch Solarkollektoren genannt bezeichnen Vorrichtungen, welche das vorhandene Sonnenlicht in thermische Energie umwandeln und diese über ein Übertragungsmedium abführen.

Photovoltaische Elemente, wie beispielsweise Solarzellen oder photovoltaische Zellen wandeln elektromagnetische Strahlung, in der Regel Sonnenlicht, direkt in elektrische Energie um.

Die Erzeugung von Solarenergie und die Erzeugung von pflanzlichen Nahrungsmitteln stehen daher in Konkurrenz zueinander. Damit auf identischen Flächen sowohl Pflanzen gedeihen können und auch Solarenergie gewonnen werden kann, wäre es mithin notwendig, transparente Sonnenkollektoren zur Verfügung zu stellen, unter denen im Betriebszustand der Sonnenkollektoren Pflanzen gedeihen können. Transparente Sonnenkollektoren sind derzeit nicht bekannt. Zunächst erscheint die Idee eines transparenten Sonnenkollektors widersprüchlich, da das Licht in andere Energieformen umgewandelt werden soll und folglich unter dem Sonnenkollektor nicht mehr zur Verfügung steht.

Solarthermische Elemente oder photovoltaische Einheiten sind aber in Bezug auf die Bandbreite des angebotenen elektromagnetischen Spektrums limitiert. Photovoltaische Elemente arbeiten im visuellen Spektrum und im UV-Spektrum, können jedoch auch Infrarotstrahlung nutzen. Solarthermische Einheiten haben ihre beste Wandlungseffizienz im Bereich der Infrarotstrahlung. Pflanzen haben ebenfalls ein eingeschränktes Wellenlängenintervall, in dem sie zur Photosynthese in der Lage sind. Das befindet sich im visuellen Spektrum (ca. 380 bis 780 Nanometer).

In der DE 10 2009 031 896 A1 wird ein transparenter Sonnenkollektor offenbart, in welchem eine solarthermische Einheit an der Stirnfläche einer Glasscheibe angeordnet ist. Infrarotstrahlung wird durch eine Hologrammfolie soweit gebrochen, dass diese innerhalb der Glasscheibe zur Seite hin abgelenkt wird. Das visuelle Licht hingegen scheint durch die Glasfläche hindurch. Dort, wo solarthermische Einheiten stehen, wäre es mithin interessant, neben der reinen solarthermischen Energie auch elektrische Energie aus Sonnenlicht zu erzeugen.

Aufgabe der Erfindung ist es, einen transparenten Sonnenkollektor zur Verfügung zu stellen, der Solarenergie effizienter nutzt.

### DARSTELLUNG DER ERFINDUNG

Die der Erfindung zu Grunde liegende Aufgabe wird dadurch gelöst, dass ein photovoltaisches Element auf der solarthermischen Einheit aufsitzt, wobei das photovoltaische Element Wärmestrahlung aus der transparenten Fläche in die solarthermische Einheit überträgt. Weitere vorteilhafte Ausgestaltungen sind in den Unteransprüchen angegeben. Des Weiteren sind ein Verfahren zur Erzeugung von Solarenergie und die Verwendung eines erfindungsgemäßen Sonnenkollektors angegeben.

Ein weiteres Ziel der Erfindung ist die Nutzung der thermischen und photovoltaischen Anteile der Solarenergie.

Vorteilhaft sind mehrere photovoltaische Elemente am Umfang der transparenten Fläche angeordnet. D.h. es können solche Elemente seitlich, links und rechts, oder ober- und unterhalb einer transparenten Fläche eines Sonnenkollektors angeordnet sein. Die Anordnung kann stirnseitig oder benachbart zur Stirnseite auf der Vorder- oder Rückseite der transparenten Fläche erfolgen.

Ein erfindungsgemässer Sonnenkollektor weist mindestens eine zum Teil transparente Fläche, eine Ebene mit mindestens einem diffraktiven optischen Element, wobei das diffraktive optische Element elektromagnetische Strahlung eines ersten vorbestimmten Wellenlängenintervalls nicht, oder nur so stark beugt, dass ein innerer Glanzwinkel nicht unterschritten wird und die elektromagnetische Strahlung mit dem ersten vorbestimmten Wellenlängenintervall durch eine einer Einfallfläche gegenüberliegenden Rückseite der transparenten Fläche austritt und die elektromagnetische Strahlung mit einem zweiten vorbestimmten Wellenlängenintervall so stark beugt, dass der innere Glanzwinkel unterschritten wird und die elektromagnetische Strahlung mit dem vorbestimmten Wellenlängenintervall durch eine seitliche Stirnfläche der transparenten Fläche austritt und mindestens eine solarthermische Einheit aufweist, wobei die solarthermische Einheit seitlich der seitlichen Stirnfläche der transparenten Fläche angeordnet ist, wobei mindestens ein photovoltaisches Element derart benachbart zur transparenten Fläche angeordnet ist, dass aus der transparenten Fläche ausgekoppelte elektromagnetische Strahlung dieses bestrahlen. Benachbart bedeutet in dieser Anmeldung, dass zwei Elemente mittelbar, unmittelbar oder beabstandet zueinander angeordnet sind.

Nach einer Ausführungsform der Erfindung ist vorgesehen, dass eine in einem Sonnenkollektor vorhandene solarthermische Einheit am Rand der zum Teil transparenten Fläche angeordnet ist, wobei ein photovoltaisches Element auf der solarthermischen Einheit aufsitzt. Die photovoltaische Einheit erzeugt elektrische Energie aus dem zur Verfügung gestelltem Licht. Dabei heizt sich die photovoltaische Einheit auf und gibt ihrerseits die Wärme an die darunter liegende solarthermische Einheit ab. Die solarthermische Einheit und das photovoltaische Element wirken im Verbund. Die Kühlung des photovoltaischen Elements bedingt seinen besseren Wirkungsgrad, wobei die Abfallwärme durch die solarthermische Einheit abgeführt wird.

Alternativ oder zusätzlich sind ein oder mehrere photovoltaische Elemente an oder in der transparenten Fläche angeordnet. Diese Anordnung ist vor allem bei breiten Glasscheiben vorteilhaft, da bei langen Laufwegen des Lichts Verluste auftreten und weniger Licht in Wärme- oder Elektroenergie umgewandelt werden kann. Ein in der transparenten Fläche angeordnetes photovoltaisches Element wandelt so Licht in Strom um, das andernfalls verlustreich bis zur Stirnseite wandern würde und erhöht somit die Energieausbeute, vor allem bei breiten oder dünnen Glasscheiben. Insbesondere für Scheiben ab einer Lauflänge je Richtung von 30 Zentimetern oder für Scheiben die dünner als 6 mm sind. Insbesondere sind breite Glasscheiben solche, die eine Breite von mehr als 60 Zentimeter, insbesondere mehr als 1 Meter oder mehr als 2 Meter aufweisen. Die Höhe der Scheibe ist in diesem Zusammenhang nicht relevant, wenn die erfindungsgemässe Folie so ausgerichtet und ausgestaltet ist, dass einfallendes Licht nur in Richtung der Seitenbereiche gebeugt wird. Bei einem weiteren Ausführungsbeispiel können solche Folien auch so angeordnet und ausgestaltet sein, zum Beispiel schachbrettmustermässig, dass die Beugung jeweils in beide senkrecht zueinander ausgerichtete Richtungen zu den vier Kanten der Scheibe erfolgt.

Durch die Erfindung wird erreicht, dass das auf den Sonnenkollektor einfallende Licht in zwei Fraktionen aufgeteilt werden kann. Eine Fraktion des Lichtes passiert die transparente Fläche und steht unterhalb des Sonnenkollektors zur Verfügung. Hingegen steht das zum photovoltaischen Element und/oder zur solarthermischen Einheit weitergeleitete Licht zur Erzeugung von Solarenergie zur Verfügung. Die Fraktion des Lichts, welche die transparente Fläche passiert, weist einen Wellenlängenbereich von ca. 380 bis 780 Nanometer auf und die Fraktion des Lichts, welche zum photovoltaischen Element und/oder zur solarthermischen Einheit weitergeleitet wird wiest einen Wellenlängenbereich von ca. 780 bis 1800 Nanometer auf.

Nach einer vorteilhaften Ausgestaltung der Erfindung ist vorgesehen, dass die zum Teil transparente Fläche mindestens eine Ebene mit einem diffraktiven optischen Element (DOE) aufweist, welches elektromagnetische Strahlung eines vorbestimmten Wellenlängenintervalls so stark beim Eintreffen auf die transparente Fläche beugt, dass der innere Glanzwinkel ϑ der zum Teil transparenten Fläche unterschritten wird und die elektromagnetische Strahlung durch Totalreflexion zum Rand gelenkt wird und dort an einem genau bestimmten Bereich der zum Teil transparenten Fläche austritt. Das kann an der Stirnseite und/oder nahe dieser oberhalb und/oder unterhalb der Glasscheibe sein. Das bedeutet, dass auf die zum Teil transparente Fläche einfallendes Licht durch das diffraktive optische Element in seine spektralen Anteile zerlegt wird. Dabei wird durch das diffraktive optische Element nur ein ausgesuchter Teil des von der Sonne scheinenden Lichtspektrums gebeugt. Alle anderen Teile des Lichtspektrums der Sonne gelangen hingegen ungehindert durch die zum Teil transparente Fläche auf der der Eintrittsseite gegenüberliegenden Seite der zum Teil transparenten Fläche des Sonnenkollektors in den Raum hinter dem Kollektor.

Das einfallende Licht trifft direkt auf die transparente Fläche, wenn weder ein diffraktives optisches Element noch eine zweite transparente Fläche in der Form einer Schutzfolie oder einer Glasplatte noch ein photovoltaisches Element auf der ersten transparenten Fläche vorgesehen sind und trifft auf das diffraktive optische Element, wenn nur ein solches vorgesehen ist, oder ein solches über dem photovoltaischen Element angeordnet ist. Ist eine Schutzfolie oder eine Glasplatte bezüglich der Strahlungsrichtung über der ersten transparenten Fläche, dem diffraktiven optischen Element und gegebenenfalls dem photovoltaischen Element angeordnet, so trifft das einfallende Licht auf diese. D.h. je nach der Anordnung oder dem Vorhandensein der oben aufgeführten Komponenten wird die Einfallfläche des Kollektors für das einfallende Licht durch eine dieser Komponenten gebildet.

Diffraktive optische Elemente funktionieren nach dem physikalischen Prinzip der Beugung

(auch Diffraktion genannt) an einem optischen Gitter. Beispielsweise sind diffraktive optische Elemente Glasträger, auf die durch Fotolithografie Mikrostrukturen, wie zum Beispiel optische Gitter, aufgebracht werden. Vorzugsweise ist das diffraktive optische Element als eine Folie ausgebildet, welche mittels eines optischen Gitters das auftreffende Licht in mehrere Teilstrahlen aufteilt oder Teile des Lichtes in unterschiedliche Weise beugt. Solche Folien werden auch als holographische oder Hologrammfolien bezeichnet. Diese Hologramme können durch Volumenhologramme oder Prägehologramme gebildet sein und als Reflexionshologramme und/oder Transmissionshologramme ausgestaltet sein.

Durch die Ausgestaltung des diffraktiven optischen Elements kann festgelegt werden, welcher Teil des Lichtes in den Bereich hinter der zum Teil transparenten Fläche eindringt und welcher Teil seitlich, in Richtung der Stirnseite gelenkt wird. Dadurch kann eine Erwärmung des sich hinter der zum Teil transparenten Fläche befindlichen Raumes verhindert oder in Grenzen gehalten werden. Es kann aber auch die Zusammensetzung des sichtbaren Lichtes verändert und eine optische Wirkung erzielt werden.

Es ist nach dieser vorteilhaften Ausgestaltung der Erfindung also vorgesehen, dass das durch das diffraktive optische Element nicht gebeugte Licht durch die zum Teil transparente Fläche hindurch scheint. Hingegen wird ein ausgesuchter Bereich des solaren Spektrums in die transparente Fläche geleitet, wo es parallel zur Ebene der zum Teil transparenten Fläche zu deren seitlichen Stirnfläche wie durch einen Lichtleiter geleitet wird. An dieser Stelle sind photovoltaische Elemente angeordnet und/oder solarthermische Einheiten angeordnet.

Zur Vermeidung der Absorption des Lichtes im vergleichsweise weiten Weg quer durch die zum Teil transparente Fläche im Vergleich zum Lichtweg durch die zum Teil transparente Fläche ist vorgesehen, dass die zum Teil transparente Fläche beispielsweise aus absorptionsarmen Material wie Plexiglas, TROGAMID oder eisen(II)-freiem Glas, bevorzugt aus Quarzglas besteht. Bekanntes Fensterglas weist einen relativ hohen Anteil an Eisen(II) auf, das dem Glas den typischen grünlichen Schimmer verleiht. Für den Einsatz als zum Teil transparente Fläche in dieser Erfindung hat es sich jedoch als günstiger erwiesen, wenn ein Eisen(II)-freies Glas, im besten Fall ein Quarzglas verwendet wird, das die gebeugte Lichtstrahlung bei dem Weg parallel zur Ebene des Glases nicht absorbiert.

In einer besonderen Ausführungsform der Erfindung ist vorgesehen, dass das durch das diffraktive optische Element gebeugte Licht sowohl Infrarotstrahlung als auch Teile des visuellen Lichtes und/oder des UV-Lichtes beugt und somit aus dem normalen Lichtweg entfernt und in das photovoltaische Element und/oder in die solarthermische Einheit am Rand der zum Teil transparenten Fläche leitet, wo die Stirnfläche vorliegt. Dabei ist das photovoltaische Element auf einer solarthermischen Zelle aufgesattelt. Die bei der Erzeugung von elektrischem Strom entstehende Wärme in dem photovoltaischen Element wird durch die solarthermische Einheit, auf welche die photovoltaische Einheit aufgesattelt ist, aufgenommen und als Wärme in einem flüssigen Wärmeträger abtransportiert. Die solarthermische Einheit dient somit einerseits als Kühlelement für das photovoltaische Element und andererseits wird durch die solarthermische Einheit Wärme erzeugt.

Um die Temperatur des Wärmeträgers zu steuern, ist nach der Erfindung vorgesehen, dass der Volumenstrom des Wärmeträgers in der solarthermischen Einheit steuerbar ist. Dazu ist ein Steuerventil vorgesehen, dass die Durchflussmenge eines flüssigen Wärmeträgers in der solarthermischen Einheit limitiert. Je geringer der Volumenstrom des Wärmeträgers ist, desto höher ist die Temperatur des Wärmeträgers. Da der Energieeintrag durch die Sonne und der Energieabtransport eines thermisch eingeschwungenen Sonnenkollektors im Gleichgewicht stehen, ist der Energietransport des Wärmeträgers nahezu konstant. Weist der Volumenstrom eine geringe Größe auf, so erhöht sich die Wärmemenge im Wärmeträger, was mit einem Ansteigen der Temperatur einhergeht. Je höher die Temperatur des Wärmeträgers ist, desto besser lässt sich die Wärme in einem späteren Wärmetauscher ausbeuten. Allerdings ist zu berücksichtigen, dass bei sehr hohen Temperaturen ein Verlust durch Wärmestrahlung auftritt und auch, dass die Handhabung der Hitze Probleme bei Dichtungen und bei der Auslegung von Verrohrungen hervorruft, beispielsweise durch thermische Ausdehnung.

Nach einer Ausgestaltung der Erfindung ist es vorteilhaft, wenn ein Rahmen für die transparente Fläche vorgesehen ist, in welchem das photovoltaische Element und/oder die solarthermische Einheit angeordnet sind, wobei der Rahmen Kupplungselemente aufweist, mit welchen ein erster Sonnenkollektor mit einem korrespondierenden zweiten Sonnenkollektor in der Fläche kraftschlüssig, wärmeschlüssig und/oder elektrisch stromschlüssig verbindbar ist. Es ist nach dem Gedanken der Ausgestaltung der Erfindung also vorgesehen, dass mehr als ein Sonnenkollektor zu einer größeren Fläche zusammengeschlossen werden kann. Dabei sollen die Sonnenkollektoren kraftschlüssig miteinander verbunden werden. Das bedeutet, dass die Sonnenkollektoren ohne weiteren Unterbau zu einer Fläche verbunden werden können. Neben der kraftschlüssigen Verbindung können auch wärmeschlüssige Verbindungen vorhanden sein. Dies bedeutet, dass Rohr oder Schlauchverbindungen vorhanden sind, die ineinander greifen und den Wärmeträger von einer solarthermischen Einheit in die nächste weiterleiten, bis der Wärmeträger die aufgenommene Wärme in einem an die Vielzahl von verbundenen Sonnenkollektoren angebundenen Wärmetauscher abgibt.

Um das diffraktive optische Element vor Witterung zu schützen, ist in Ausgestaltung der Erfindung vorgesehen, dass das diffraktive optische Element zwischen zwei transparenten Flächen angeordnet ist. Es ist möglich, das diffraktive optische Element ungeschützt auf der Oberfläche der transparenten Fläche anzuordnen. Aber langlebiger hat sich ein diffraktives optisches Element gezeigt, das eine Schutzfolie oder ein Schutzglas zum Schutz gegenüber der Witterung aufweist und daher zwischen zwei transparenten Flächen angeordnet ist.

Der Einsatz der beschriebenen Sonnenkollektoren mit zum Teil transparenten Flächen eignet sich in besonderer Weise für Gewächshäuser, für große Glasfassaden von Hochhäusern oder für Glasdächer einer Halle. Das Besondere der zum Teil transparenten Sonnenkollektoren ist, dass sie wegen der Ableitung der Infrarotstrahlung zu der solarthermischen Einheit wie ein Infrarotfilter im Glas wirken. Das durch den zum Teil transparenten Sonnenkollektor scheinende Licht wirkt natürlich, weist aber kein oder nur wenig UV-Licht auf und keine oder nur wenig Infrarotstrahlung, so dass der typische Treibhauseffekt ausbleibt. Dies ist besonders vorteilhaft für Gewächshäuser in südlich gelegenen Orten, bei denen die Wärme durch Lüftung abgeleitet werden muss, wobei mit der Wärmeableitung auch Feuchtigkeit verloren geht, die in trockenen, heißen Gebieten unter Kostenaufwand nachgeliefert werden muss.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine Skizze eines Querschnitts eines erfindungsgemäßen Sonnenkollektors;
- Fig. 2: eine Skizze eines Querschnitts einer alternativen Ausführungsform eines erfindungsgemässen Sonnenkollektors; und
- Fig. 3: eine Skizze eines Querschnitts einer weiteren alternativen Ausführungsform eines erfindungsgemässen Sonnenkollektors.

### BESCHREIBUNG BEVORZUGTER AUSFÜHRUNGSFORMEN

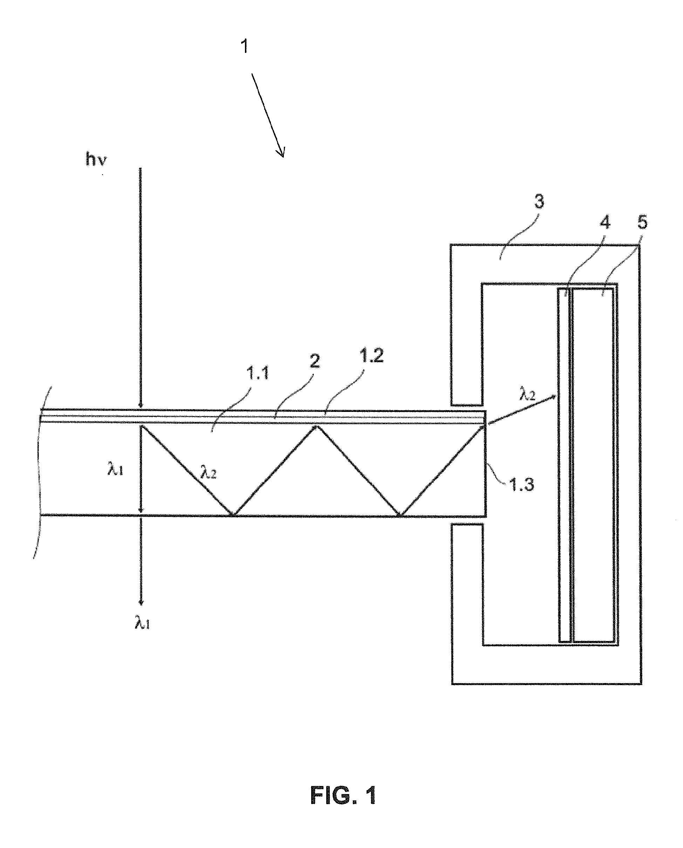

In Figur 1 ist eine Skizze eines Querschnitts durch einen Sonnenkollektor 1 dargestellt mit einer transparenten Fläche 1.1. Diese transparente Fläche 1.1 wird beim Bescheinen durch Sonnenlicht hᵥ von einem Teil λ₁ des angebotenen Sonnenspektrums durchschienen während ein zweiter Teil λ₂ des angebotenen Sonnenspektrums hᵥ durch ein diffraktives optisches Element 2 gebeugt wird und zwar mit einem Winkel, bei dem der innere Glanzwinkel ϑ, bei dem die Totalreflexion eintritt, unterschritten wird. Dadurch wird dieser durch das diffraktive optische Element gebeugte Lichtstrahl mit dem zweiten Teil des Lichtes, mit dem Wellenlängenbereich λ₂ des angebotenen Sonnenspektrums hᵥ, innerhalb der transparenten Fläche 1.1, wie in einem Lichtleiter, zur seitlichen Stirnfläche 1.3 durch mehrfache Totalreflexion geleitet, wo dieser Lichtstrahl aus der transparenten Fläche 1.1 austritt und in eine seitlich an die transparente Fläche 1.1 angebrachte Anordnung 3, beispielsweise in der Form eines Rahmens, eintritt. Mit λ₁ und λ₂ wird jeweils eine bestimmte Bandbreite des Wellenlängenbereiches der elektromagnetischen Strahlung beschrieben. So kann λ₁ zum Beispiel im Wellenlängenbereich des sichtbaren Lichtes von 340 Nanometer bis 740 Nanometer sein und λ₂ beispielsweise im infraroten Bereich von 740 Nanometer und 1.400 Nanometer. λ₁ könnte jedoch auch nicht zusammenhängende Bereiche des visuellen Lichtes umfassen, während λ₂ zum Teil aus Bereichen des visuellen Lichtes und Bereichen des Infraroten Lichtes oder aus dem gesamten Lichtspektrum bestehen kann. In Anordnung 3 befindet sich ein photovoltaisches Element 4, das von dem aus der transparenten Fläche 1.1 ausgetretenen Lichtstrahl beschienen wird und dort photovoltaisch elektrischen Strom produziert. Bei der Produktion von elektrischem Strom heizt sich das photovoltaische Element auf, weil es entweder nicht vollständig das angebotene Licht in elektrischen Strom umsetzt oder weil in dem gebeugten Lichtstrahl mit dem Wellenlängenbereich λ₂ Lichtquanten vorhanden sind, die von dem photovoltaischen Element 4 nicht in elektrischen Strom umgesetzt werden. Diese nicht umgesetzten Lichtquanten können auch aus infrarotem Licht stammen, das zur Erzeugung von Wärme in dem gebeugten Lichtstrahl mit dem Wellenlängenbereich λ₂ in gewünschter Weise vorhanden ist.

Das photovoltaische Element 4 kann die gleichen Abmessungen aufweisen wie die Gesamtheit der seitlichen Stirnflächen 1.3 der transparenten Flächen 1.1, 1.2 oder es kann diese überragen oder dieser zurückstehen. Es kann einteilig oder mehrteilig ausgebildet sein.

Um das photovoltaische Element einerseits zu kühlen und um andererseits Wärme zu erzeugen, ist eine solarthermische Einheit 5 hinter dem photovoltaischen Element 4 angeordnet, so dass das photovoltaische Element 4 auf der solarthermischen Einheit aufsitzt und die eigene Wärme an die solarthermische Einheit abgibt. Der durch das photovoltaische Element in bekannter Weise erzeugte elektrische Strom und die durch die solarthermische Einheit in bekannter Weise erzeugte Wärme werden sodann mit Hilfe von elektrischen Verbindungen und/oder durch eine Leitung für einen Wärmeträger abgeführt.

Die Abmessungen der solarthermischen Einheit 5 entsprechen denen des dazugehörigen photovoltaischen Elements 4. Die solarthermischen Einheit 5 kann seitlich über das photovoltaischen Element 4 hinausragen oder zu diesem zurückversetz sein.

Um mehr als einen Sonnenkollektor 1 mechanisch, elektrisch oder wärmeschlüssig miteinander zu verbinden, können die Anordnungen 3 als Rahmen ausgeführt sein, welche zueinander korrespondierende elektrische Verbinder, mechanische Verbinder und/oder Rohrkupplungen aufweisen.

Das photovoltaische Element 4 kann mit der solarthermischen Einheit 5 verklebt, verschweisst oder anderweitig verbunden sein. Die solarthermischen Einheiten 5 können einen Bestandteil der Rahmenanordnung 3 bilden oder können in dieser angeordnet oder mit dieser verbunden sein. Durch die Anordnung der transparenten Flächen zusammen mit dem mindestens einen diffraktiven optischen Element 2 in der Rahmenanordnung 3 wird die seitliche Positionierung des photovoltaischen Elements 4 zur seitlichen Stirnfläche 1.3 der transparenten Fläche 1.1 realisiert.

Alternativ kann das zweite photovoltaische Element 4 mit der seitlichen Stirnfläche 1.3 der transparenten Fläche 1.1 verbunden, beispielsweise verklebt oder verschweisst sein. Die solarthermischen Einheiten 5 können ebenfalls mit den entsprechenden photovoltaischen Elementen 4 verbunden, beispielsweise verklebt oder verschweisst sein.

Diese Einheit aufweisend kann mindestens eine transparente Fläche 1.1, mindestens ein diffraktives optisches Element 2, mindestens ein photovoltaisches Element 4 und mindestens eine solarthermische Einheit 5 in eine Rahmenanordnung 3 eingesetzt werden, bzw. eine Rahmenanordnung 3 kann um diese Einheit angeordnet werden, was die Montage, beispielsweise der elektrischen und mechanischen Verbinder sowie der Rohrkupplungen wesentlich vereinfacht.

Zum Schutz des diffraktiven optischen Elements 2 ist eine zweite transparente Fläche 1.2 auf diesem angeordnet, um dieses vor Umwelteinflüssen zu schützen.

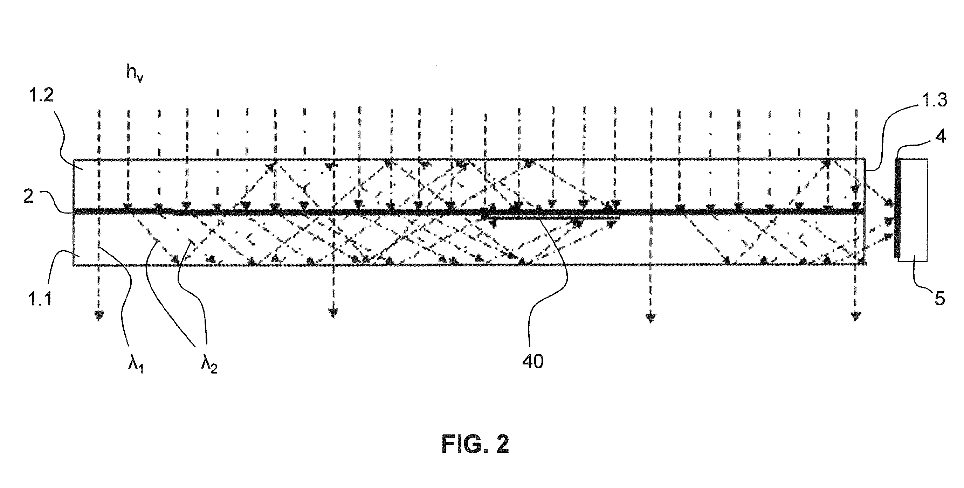

Die Figur 2 zeigt eine Skizze eines Querschnitts einer alternativen Ausführungsfonn eines erfindungsgemässen Sonnenkollektors. Das mindestens eine diffraktive optische Element 2 ist innerhalb der transparenten Fläche, d.h. zwischen einer ersten transparenten Fläche 1.1 und einer zweiten transparenten Fläche 1.2 angeordnet, wobei die zweite transparente Fläche 1.2 im Wesentlichen die gleichen Dimensionen wie die erste transparente Fläche 1.1 aufweist.

Zusätzlich oder alternativ zum photovoltaischen Element 4, welches benachbart oder anschliessend zur seitlichen Stirnfläche 1.3 der ersten und zweiten transparenten Fläche 1.1, 1.2 angeordnet ist, ist ein zweites photovoltaisches Element 40 vorgesehen, welches in Strahlungsrichtung benachbart oder anschliessend zur transparenten Fläche 1.1 angeordnet ist. In der Figur 2 dargestellt ist ein photovoltaisches Element 49, welches hinter dem diffraktiven optischen Element 2 und zwischen diesem und der transparenten Fläche 1.1, parallel zu dieser angeordnet ist.

Vorzugsweise ist das photovoltaische Element 4, 40 beabstandet zur Oberfläche der transparenten Fläche 1.1, 1.2 angeordnet, es kann jedoch auch unmittelbar auf dieser angeordnet sein. Alternativ kann das zweite photovoltaische Element 40 parallel zur transparenten Fläche 1.1 im diffraktiven optischen Element 2 eingebettet sein.

Von den zweiten photovoltaischen Elementen 40 führen elektrische Leitungen zur seitlichen Stirnfläche 1.3, wo sie für die Weiterleitung des erzeugten Stromes in einem nicht dargestellten Rahmen, ähnlich wie in Figur 1 dargestellt, gebündelt werden.

Das einfallende Licht hᵥ tritt durch die zweite transparente Fläche 1.2 hindurch und wird, wie oben beschrieben und wie in Figur 1 dargestellt in zwei Wellenlängenbereiche λ₁, λ₂ aufgeteilt, wobei λ₁ den Wellenlängenbereich des Lichts bezeichnet, welcher durch die erste transparente Fläche 1.1 hindurchscheint und λ₂ den Wellenlängenbereich des Lichts bezeichnet, welcher zur seitlichen Stirnfläche 1.3 umgelenkt wird.

Im Unterschied zur Figur 1 wird das einfallende Licht hᵥ, sowie das Licht der zwei Wellenlängenbereiche λ₁, λ₂ durch das zweite photovoltaische Element 40 in elektrischen Strom umgewandelt. Dies gilt für das Licht, dass durch die Eintrittsfläche durch die zweite transparente Fläche 1.2 auf das zweite photovoltaische Element 40 auftritt, als auch für das, welches nach der Reflektion an der der Eintrittsfläche gegenüberliegenden Rückwand der ersten transparenten Fläche 1.1 auf das zweite photovoltaische Element 40 auftritt.

Das photovoltaische Element 40 wandelt beidseitig das auftreffende Licht in elektrischen Strom um.

Die transparenten Flächen 1.1, 1.2 können mit dem diffraktiv optischen Element 2 und dem photovoltaischen Element 4, 40 verklebt, verschweisst oder auf andere Art und Weise verbunden werden.

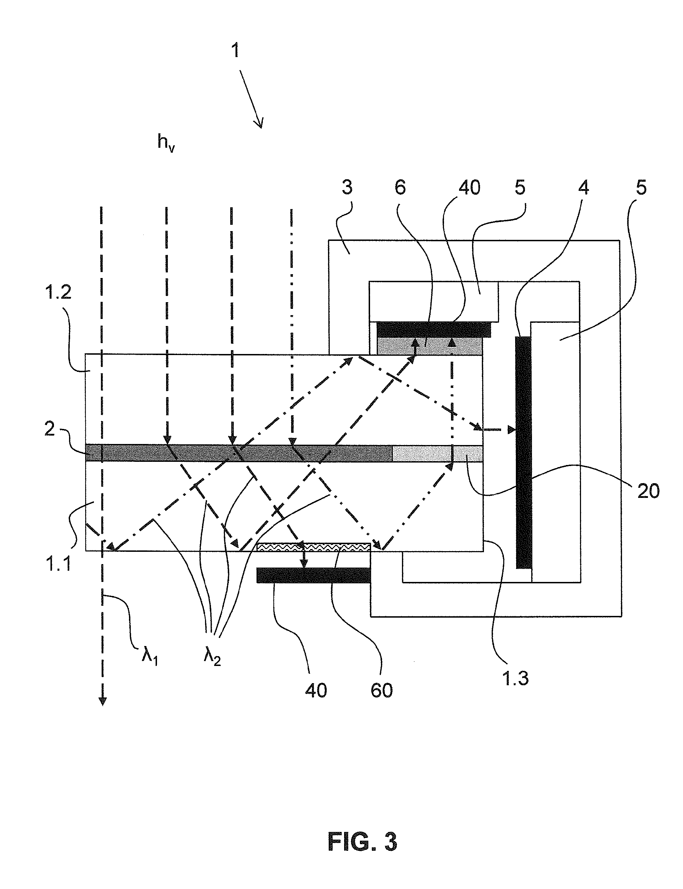

Figur 3 zeigt eine Skizze eines Querschnitts einer weiteren alternativen Ausführungsform eines erfindungsgemässen Sonnenkollektors. Im Unterschied zur in der Figur 2 dargestellten Ausführungsform weist der Sonnenkollektor ein photovoltaisches Element 40 auf, welches benachbart zum zweiten transparenten Element 1.2 auf der Seite der Einfallfläche angeordnet ist. Dargestellt ist im Weiteren ein Übertragungselement 6, welches das in der transparenten Fläche 1.1, 1.2 geführte Licht, auf der Einfallseite kurz vor der seitlichen Stirnseite 1.3, bzw. an diese anschliessend, in Richtung des photovoltaischen Elements 40 führt. Das photovoltaische Element kann jedoch auch unmittelbar auf der Einfallseite auf der Oberfläche der transparenten Fläche 1.1 angeordnet oder mit dieser verklebt oder verschweisst sein.

Analog zur Ausführungsform der Figur 1 kann das photovoltaische Element 40 auf einer solarthermischen Einheit 5 angeordnet sein, muss es aber nicht. Das dargestellte photovoltaische Element 40 und die dazugehörige solarthermische Einheit 5 sind vollständig innerhalb der als Rahmen ausgebildeten Anordnung 3 angeordnet.

Auf der der Einfallsseite gegenüberliegenden Rückseite der transparenten Fläche 1.1 kann alternativ oder zusätzlich ein photovoltaisches Element 40 kurz vor der seitlichen Stirnseite 1.3, bzw. beabstandet zu dieser, angeordnet sein. Das photovoltaische Element 40 kann beabstandet zur rückseitigen Oberfläche der transparenten Fläche oder direkt auf dieser angeordnet sein. Es kann ebenfalls verklebt oder verschweisst sein oder es kann ein Übertragungselement aufweisen, welches das in der transparenten Fläche geführte Licht in Richtung des photovoltaischen Elements 40 führt.

Um zu verhindern, dass das in der transparenten Fläche 1.1 geführte Licht an deren rückseitigen Oberfläche im Bereich der photovoltaischen Elements 40 reflektiert wird, ist in diesem Bereich eine Oberflächenveränderung 60 in die transparente Fläche 1.1 eingebracht, beispielsweise durch deren anschleifen.

Das in Figur 3 dargestellte photovoltaische Element ist ausserhalb der als Rahmen ausgebildeten Anordnung 3 angeordnet. Alternativ kann sie jedoch in diesem angeordnet sein oder mit einer separaten Halterung an diesem anordnungsbar sein.

Alternativ oder zusätzlich kann ein zweites diffraktives optisches Element 20 im Bereich der seitlichen Stirnfläche 1.3 in der gleichen Ebene wie das erste diffraktive optische Element 2 angeordnet sein. Beispielsweise könnte das zweite diffraktive optische Element 20 einen teilweisen oder vollständigen Rahmen um das erste diffraktive optische Element 2 bilden. Durch das zweite diffraktive optische Element 20 wird das in der transparenten Fläche 1.1, 1.2 geführte Licht an diesem gebeugt und der Einfallswinkel auf die Oberfläche der transparenten Fläche 1.1, 1.2 so geändert, dass das Licht nicht mehr reflektiert wird, sondern durch die Oberfläche hindurchtritt, wo es auf ein sich dort befindliches photovoltaisches Element 40 auftreten kann.

Das zweite diffraktive optische Element 20 ist mit dem ersten 2 und den transparenten Flächen 1.1, 1.2 verklebbar oder verschweissbar.

Die beschriebene Art der Ausgestaltung und der Anordnung der einzelnen Elemente der einzelnen Ausführungsformen sind beliebig unter den Ausführungsformen austauschbar oder kombinierbar.

Durch die zusätzliche Anordnung von photovoltaischen Elementen 4, 40 benachbart zur seitlichen Stirnfläche 1.3 oder parallel zur Einfallfläche der transparenten Fläche 1.1, 1.2 kann die für die Stromerzeugung wirksame Gesamtoberfläche vergrössert werden, was zu einer besseren Ausnutzung des vorhandenen Sonnenlichts und somit zu einer effizienteren Nutzung der vorhandenen Solarenergie führt.

### BEZUGSZEICHENLISTE

| | | | |
|---|---|---|---|
| 1 | Sonnenkollektor | | Element |
| 1.1 | Transparente Fläche | 5 | Solarthermische Einheit |
| 1.2 | Zweite transparente Fläche | 6 | Übertragungselement |
| 1.3 | Stirnfläche | 60 | Oberflächenveränderung |
| 2 | Diffraktives optisches | hᵥ | Sonnenspektrum |
| | Element | λ₁ | Licht mit |
| 20 | Zweites diffraktives optisches | | Wellenlängenbereich |
| | Element | λ₂ | Licht mit |
| 3 | Anordnung | | Wellenlängenbereich |
| 4 | Photovoltaisches Element | ϑ | Glanzwinkel |
| 40 | Zweites photovoltaisches | | |

## Patentansprüche

1. Sonnenkollektor (1), aufweisend mindestens eine zum Teil transparente Fläche (1.1), eine Ebene mit mindestens einem diffraktiven optischen Element (2), wobei das diffraktive optische Element (2) elektromagnetische Strahlung eines ersten vorbestimmten Wellenlängenintervalls (λ₁) nicht, oder nur so stark beugt, dass ein innerer Glanzwinkel (ϑ) nicht unterschritten wird und die elektromagnetische Strahlung mit dem ersten vorbestimmten Wellenlängenintervall (λ₁) durch eine einer Einfallfläche gegenüberliegenden Rückseite der transparenten Fläche (1.1) austritt und die elektromagnetische Strahlung mit einem zweiten vorbestimmten Wellenlängenintervall (λ₂) so stark beugt, dass der innere Glanzwinkel (ϑ) unterschritten wird und die elektromagnetische Strahlung mit dem vorbestimmten Wellenlängenintervall (λ₂) durch eine seitliche Stirnfläche (1.3) der transparenten Fläche (1.1)oder eine andere dafür bestimmte Fläche austritt und mindestens eine solarthermische Einheit (5), wobei die solarthermische Einheit (5) seitlich der seitlichen Stirnfläche (1.3) der transparenten Fläche (1.1)angeordnet ist, **dadurch gekennzeichnet, dass** mindestens ein photovoltaisches Element (4, 40) derart benachbart zur transparenten Fläche (1.1) angeordnet ist, dass aus der transparenten Fläche (1.1, 1.2) ausgekoppelte elektromagnetische Strahlung (λ₁, λ₂) dieses bestrahlen.

2. Sonnenkollektor nach Anspruch 1, **dadurch gekennzeichnet, dass** das mindestens eine photovoltaische Element (40) parallel zur Einfallfläche der transparenten Fläche (1.1, 1.2) angeordnet ist.

3. Sonnenkollektor nach Anspruch 1 oder 2, **dadurch gekennzeichnet, dass** das photovoltaische Element (4) benachbart zur seitlichen Stirnseite (1.3) der transparenten Fläche 1.1 angeordnet ist und auf der solarthermischen Einheit (5) aufsitzt, wobei das photovoltaische Element (4) Wärmestrahlung aus der transparenten Fläche (1.1) in die solarthermische Einheit (5) überträgt.

4. Sonnenkollektor nach Anspruch 3, **dadurch gekennzeichnet, dass** das photovoltaische Element (4) unmittelbar an einer Oberfläche der transparenten Fläche (1.1, 1.2) angeordnet ist.

5. Sonnenkollektor nach Anspruch 3 oder 4, **dadurch gekennzeichnet, dass** ein Volumenstrom eines Wärmeträgers in der solarthermischen Einheit (5) steuerbar ist zur Variation der Temperatur des Wärmeträgers beim Austritt aus der solarthermischen Einheit (5).

6. Sonnenkollektor nach einem der Ansprüche 1 bis 5 **dadurch gekennzeichnet, dass** die transparente Fläche (1.1) aus absorptionsarmem Material wie Plexiglas, TROGAMID oder eisen(II)-freiem Glas, bevorzugt aus Quarzglas besteht.

7. Sonnenkollektor nach einem der Ansprüche 1 bis 6, **dadurch gekennzeichnet, dass** ein Rahmen (3) für die transparente Fläche (1.1) vorgesehen ist, in welchem das photovoltaische Element (4) und/oder die solarthermische Einheit (5) angeordnet sind, wobei der Rahmen (3) Kupplungselemente aufweist, mit welchem ein erster Sonnenkollektor (1) mit einem korrespondierenden zweiten Sonnenkollektor (1) in der Fläche kraftschlüssig, wärmeschlüssig und/oder elektrisch stromschlüssig verbindbar ist.

8. Sonnenkollektor nach einem der Ansprüche 1 bis 7, **dadurch gekennzeichnet, dass** das diffraktive Optische Element (2) zwischen zwei transparenten Flächen (1.1, 1.2) angeordnet ist.

9. Sonnenkollektor nach einem der Ansprüche 1 bis 8, **dadurch gekennzeichnet, dass** ein Übertragungselement (6) zwischen der transparenten Fläche (1.1, 1.2) und dem photovoltaischen Element (4) vorhanden ist.

10. Sonnenkollektor nach einem der Ansprüche 1 bis 9, **dadurch gekennzeichnet, dass** an der im Bereich der Oberfläche der transparenten Fläche (1.1, 1.2) im Bereich des photovoltaischen Elements (4) eine Oberflächenveränderung (60) in die transparente Fläche (1.1, 1.2) eingebracht ist.

11. Sonnenkollektor nach einem der Ansprüche 1 bis 9, **dadurch gekennzeichnet, dass** ein zweites diffraktives optisches Element (20) in einer gleichen Ebene wie das erste diffraktive optische Element (2) im Bereich der seitlichen Stirnfläche (1.3) angeordnet ist.

12. Verwendung eines Sonnenkollektors (1) nach einem der Ansprüche 1 bis 11 als Dachfläche in einem Gewächshaus oder einer Halle.

13. Verwendung eines Sonnenkollektors (1) nach einem der Ansprüche 1 bis 11 als Fassade eines Gebäudes.

14. Verfahren zur Erzeugung von solarthermischer Energie unter Verwendung eines Sonnenkollektors (1) nach den Ansprüchen 1 bis 11.
